(19)

**Europäisches Patentamt**
**European Patent Office**
**Office européen des brevets**

(11) **EP 1 177 453 B1**

(12) **EUROPEAN PATENT SPECIFICATION**

(45) Date of publication and mention
of the grant of the patent:
**02.04.2008 Bulletin 2008/14**

(51) Int Cl.:
***G01R 31/02*** *(2006.01)*

(21) Application number: **00916701.6**

(22) Date of filing: **12.04.2000**

(86) International application number:
**PCT/AU2000/000315**

(87) International publication number:
**WO 2000/062084 (19.10.2000 Gazette 2000/42)**

(54) **APPARATUS AND METHOD FOR ELECTRICAL MEASUREMENTS ON CONDUCTORS**

VORRICHTUNG UND VERFAHREN ZUR ELEKTRISCHEN MESSUNGEN IN LEITUNGEN

APPAREIL ET PROCEDE DE MESURES ELECTRIQUES DE CONDUCTEURS

(84) Designated Contracting States:
**AT BE CH CY DE DK ES FI FR GB GR IE IT LI LU
MC NL PT SE**

(30) Priority: **12.04.1999 US 128745 P**

(43) Date of publication of application:
**06.02.2002 Bulletin 2002/06**

(73) Proprietor: **CHK Wireless Technologies Australia
Pty Limited
Ermington, NSW 2115 (CH)**

(72) Inventors:
• **MCCAULEY, Simon, Francis
Newcastle, NSW 2300 (AU)**
• **SWEETING, David, Keith
St Ives, NSW 2075 (AU)**

(74) Representative: **Zech, Stefan Markus et al
Meissner, Bolte & Partner GbR
Widenmayerstrasse 48
80538 München (DE)**

(56) References cited:
**WO-A-96/28739**       **US-A- 4 070 572**
**US-A- 4 529 929**     **US-A- 4 947 126**
**US-A- 5 066 904**     **US-A- 5 270 898**
**US-A- 5 473 244**     **US-A- 5 519 560**

• **'A novel transducer to replace current and
voltage in high-voltage measurements' IEEE
TRANSACTIONS ON INSTRUMENTATION AND
MEASUREMENT, vol. 45, no. 1, February 1996,**

EP 1 177 453 B1

**Description**

Field of the Invention

This invention relates broadly to developments concerning equipment for electrical measurements on conductors. The invention will be described herein with reference to fault indicators for power distribution cables, it will be appreciated, however, that the invention does have broader applications, including for example in stand alone current measurements on electrical conductors.

Background of the Invention

Equipment for detection and location of faults on power lines involve typically the measurement of the magnetic fields produced by the alternating current in power lines, using a single magnetic field sensing coil.

In substations, this involves expensive current transformers, which must also provide insulation between the power line conductor and earth potential.

There is also equipment which can be located throughout a network which does not provide its own insulation between the phase and earth potential because' it is mounted either at phase potential or at earth potential.

Such equipment normally derives a signal proportional to the average or peak magnetic field by rectifying the waveform to produce a DC voltage and this is used for the detection and location of faults. By deriving a signal proportional to the average or peak magnetic field, other waveform parameters, phase, and harmonic content information is removed from the signal. DC voltages are suitable for analogue amplification, for operating analogue control devices and for interpretation by analogue comparators.

When the power lines experience a fault, high currents flow in the conductors of the lines, producing a rapid increase in the magnetic fields around the conductors. Therefore, if an increase is detected by the equipment, this is indicative of a fault current having passed the magnetic field sensing coil. Typically, within the equipment a derivative of the output signal of the magnetic field sensing coil is produced in an analogue electronic circuit, to detect increases in the amplitude of current flow. The currents flowing in the conductors of the power lines, particularly during a fault situation, may typically vary between 5 to 25,000 Amperes. The average magnetic field around the power line conductors therefore has a high dynamic range, which is typically between 1 to 10,000.

The types of coil which may be used to measure magnetic fields in such equipment are i) air-cored coils which are typically cylindrical, ii) air-cored toroids, iii) coils, cylindrical or toroidal, which are cored with a ferromagnetic or paramagnetic medium other than air. Each type of coil has specific advantages and disadvantages. Air-cored coils do not saturate in the presence of high magnetic fields and can therefore be used to detect magnetic fields with a high dynamic range. However, with air-cored coils, particularly cylindrical coils mounted at earth potential some distance from the power line conductor, low magnetic fields generate only low induced signals in the coil and may therefore be difficult to detect accurately, in particularly when background signals may contribute to the measurements.

On the other hand, coils cored with a para- or ferromagnetic medium, increase the induced signal in the coil due to the high permeability which results in an increase of the magnetic field inside the coil due to magnetic polarisation of the medium. However, such coils have the disadvantage of saturating once the "true" magnetic field to be measured exceeds a particular value, and therefore the characteristics of fields in excess of that particular value cannot be measured with such coils.

In the equipment for detection and location of faults on power lines, the average magnetic field signal derived from the coils is processed using an analogue circuit. Some fault detectors may employ an analogue variable gain control utilising for example a variable resistor such as a Junction Field Effect Transistor (JFET) to increase the dynamic range for the measurement, however, due to the analog nature of such circuits the output signal is then not directly representative of measured magnetic field strength. In some fault detectors, such as those described in US Patent No. 4947126 and US Patent No.5270898, a gain may be employed which is switched between a high and low value by analogue circuitry utilizing for example, switches or relays. However, due to the analogue nature of such circuits, a dynamic range of greater than 16:1 is difficult to attain and scaling of the amplitude is normally lost. The amplitude of the signal in the sensing coil and that of the output signal lose their one-to-one relationship and this cannot be restored using analogue circuitry alone. The document US 5 473 244 discloses an apparatus for measuring voltages and currents using non-contacting sensory.

The equipment described above has the limitation of, providing little information on the magnetic field, waveform, phase or harmonic content and electric field waveform, phase or harmonic content preceding, during and after the fault, since the information utilised is substantially limited to the identification of sudden changes in the amplitude of the magnetic field detected by the magnetic field sensing coil. The further information about the magnetic field and electric field preceding, during and after the fault can be useful in determining the characteristics of the fault. These characteristics include the severity of the fault (ratio of fault current to pre-fault current), the time and duration of the fault current and the time for the protection equipment to operate, whether the fault was phase to phase or phase to earth, and whether the fault current was accompanied by a fuse or circuit breaker operation (loss of voltage) or a substantial variation in the voltage.

Furthermore, the equipment described above is not able to discriminate between a fault current and what is referred to as magnetising inrush currents, which are typically observed when voltage is applied to a non-faulted power system following an extended outage period. Therefore, when the equipment detects loss of system voltage, it usually inhibits its detection of faults until a predetermined period after voltage is reapplied, resulting in a period during which fault detection for the power line concerned is impossible.

Summary of the Invention

In accordance with a first aspect of the present invention there is provided a method for measuring at least one characteristic parameter of an alternating current in a conductor, the method comprising the steps of:

- measuring the magnetic field around the conductor at a point along the conductor;
- deriving an analogue voltage signal representative of the measured magnetic field;
- adding a direct current (DC) offset signal to an alternating current (AC) component of the measured magnetic field;
- amplifying the analogue voltage signal;
- converting the amplified voltage signal into a digital voltage signal;
- measuring the digital voltage signal and, when the amplitude of digital voltage signal reaches a predetermined value, adjusting a gain setting of the amplification; and
- generating an output signal representative of the parameter of the alternating current based on the amplified voltage signal and the gain setting.

The step of adding a DC offset signal allows for making the measured magnetic field suitable for amplification while substantially maintaining waveform information.

Accordingly, in at least preferred embodiments of the present invention, a large dynamic range can be realised; for the magnetic field/alternating current measurements. Preferably, the method can be used in conjunction with an air-cored coil not to be limited by a saturation effect.

The characteristic parameter of the alternating current may be one of the group of waveform characteristics of the alternating current such as amplitude of the alternating current; frequency of the alternating current; phase of the alternating current; harmonic content of the alternating current; and a derivative of the alternating current. More than one parameters may be measured simultaneously.

The method may preferably further comprise the step of integrating the analogue voltage signal for obtaining the waveform of the alternating current in the conductor.

Thereby, in at least preferred embodiments of the present invention, even low magnetic field strengths may be measured at high gain settings.

In one embodiment, the step of adding a DC offset signal comprises the step of varying the DC offset signal in response to a DC component in the digital voltage signal.

In a preferred embodiment, the method further comprises the step of digitally filtering the digital voltage signal to determine the ratio of a mains voltage signal at a mains frequency of the conductor and an harmonic voltage signal at an harmonic of the mains frequency. In one embodiment, a second harmonic is utilised for determining whether a magnetic field signal around the conductor is caused by magnetising inrush current.

Preferably, the method further comprises the step of measuring an electric field in the vicinity of the conductor; and deriving a second analogue voltage signal representative of the measured electric field in the vicinity of the conductor.

In one embodiment, the step of measuring the electric field comprises the step of placing a capacitor arrangement in the vicinity of the conductor; and the method further comprises the steps of amplifying the second analog voltage signal; converting the amplified second voltage signal into a second digital voltage signal; measuring the second digital voltage signal and, if the amplitude of the second digital voltage signal reaches a second predetermined value, adjusting a second gain setting of the second amplification; and generating a second output signal representative of at least one parameter of a voltage signal in the conductor derived from the second amplified voltage signal and the second gain setting.

The characteristic parameter of the voltage signal may be one of the group of waveform characteristics of the voltage signal such as amplitude of the voltage signal; frequency of the voltage signal; phase of the voltage signal; and harmonic content of the voltage signal. More than one parameters may be measured simultaneously.

In accordance with a second aspect of the present invention there is provided an apparatus for measuring at least one characteristic parameter of an alternating current in a conductor, the apparatus comprising:

- measuring means for measuring the magnetic field around the conductor at a point along the conductor;

- means for deriving an analogue voltage signal representative of the measured magnetic field;
- trimming means for providing a DC offset signal to an AC component of the measured magnetic field;
- amplification means for amplifying the analogue voltage signal;
- converting means for converting the amplified voltage signal into a digital voltage signal;
- gain control means for adjusting a gain setting of the amplification depending on the amplitude of the digital voltage signal; and
- means for generating an output signal representative of the parameter of the alternating current based on the amplified voltage signal and the gain setting.

The trimming means allows for making the measured magnetic field suitable for amplification while substantially maintaining waveform information.

The characteristic parameter of the alternating current may be one of the group of waveform characteristic of the alternating current such as amplitude of the alternating current; frequency of the alternating current; phase of the alternating current; and harmonic content of the alternating current. More than one parameters may be measured simultaneously.

The apparatus may preferably further comprise means for integrating the analogue voltage signal to obtain the waveform of the alternating current in the conductor.

In one embodiment, the apparatus further comprises filtering means for filtering the digital signal and means for determining the ratio of a mains voltage signal at a mains frequency of the conductor and an harmonic voltage signal at an harmonic of the mains frequency.

Preferably, the apparatus further comprises a second measuring means for measuring an electric field in the vicinity of the conductor; and means for deriving a second analogue voltage signal corresponding to the measured electric field in the vicinity of the conductor.

In one embodiment, the apparatus further comprises second amplification means for amplifying the second analog voltage signal; second converting means for converting the second amplified voltage signal into a second digital voltage signal; second gain control means for adjusting a second gain setting of the second amplification means depending on the second digital voltage signal; and a second means for generating a second output signal representative of at least one parameter of a voltage signal in the conductor derived from the second amplified voltage signal and the second gain setting.

The characteristic parameter of the voltage signal may be one of the group of waveform characteristics of the voltage signal such as amplitude of the voltage signal; frequency of the voltage signal; phase content of the voltage signal; and harmonic content of the voltage signal. More than one parameters may be measured simultaneously.

The amplification, conversion, gain control and output may be performed by the same respective components for both the electric and magnetic field measurements in the apparatus.

In one embodiment, the amplification means comprises first and second operational amplifiers in series, wherein the analogue voltage signal is applied to the non-inverting input of the first operational amplifier, and the output of the first operational amplifier is connected to the non-inverting input of the second operational amplifier.

In one embodiment, the gain control means comprises a digitally controlled analogue switch having a low "off" resistance and a high "on" resistance.

Preferably, the trimming means comprises a serial to parallel shift register, wherein the outputs of the shift register are connected to a resister network to form a digital to analogue converter.

The present invention may be more readily understood from the description of preferred forms of an apparatus for electrical measurements on conductors given below with reference to the accompanying drawings.

Brief Description of the Drawings

Figure 1 is a schematic diagram illustrating a device in accordance with one embodiment of the present invention.
Figures 2a, b and c are graphs illustrating some characteristics of the device of Figure 1.
Figure 3 is a circuit diagram showing a detail of a device in accordance with another embodiment of the present invention.
Figure 4 is a circuit diagram showing another detail of the embodiment of Figure 3.
Figure 5 is a schematic diagram illustrating a device in accordance with another embodiment of the present invention.
Figure 6 is a schematic diagram illustrating a "distance to fault calculation" method.

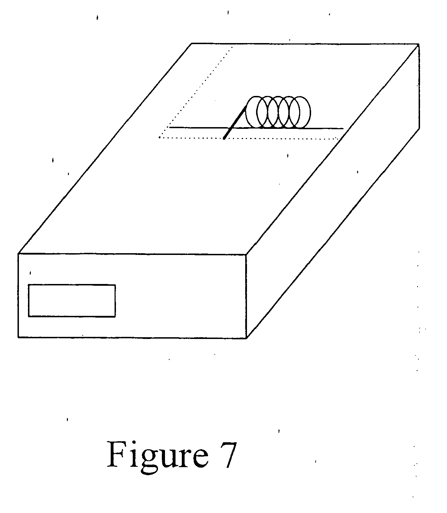

Figure 7 is a schematic, perspective view of a device in accordance with another embodiment of the present invention.

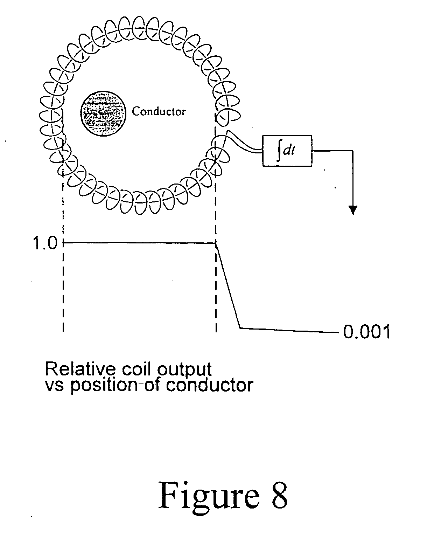

Figure 8 is a schematic diagram of a coil for use in a method and/or a device in accordance with embodiments of the present invention.

Detailed Description of the Preferred Embodiment

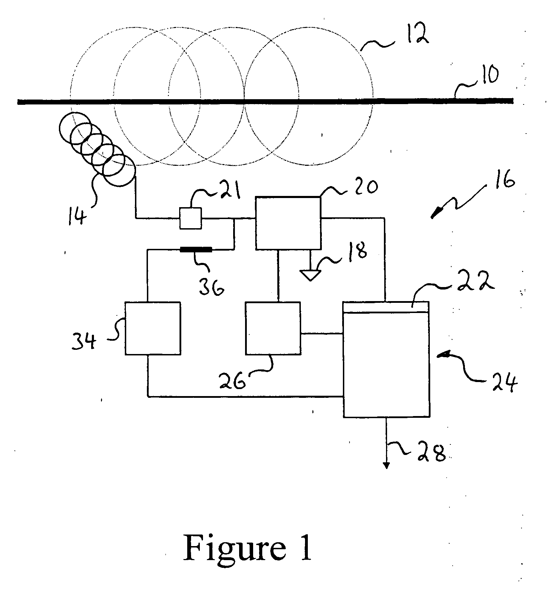

In Figure 1, an AC signal in a power line 10 generates a magnetic field 12 around the power line 10. A conductive coil 14 of the device 10 is placed in the vicinity of the power line 10 in a manner such that at least a portion of the magnetic field lines of the magnetic field 12 passes through the loops of the coil 14, thereby inducing an AC signal in the coil 14, which is connected to an internal ground 18 of the device 16 through an analogue amplification stage 20. An integrator 21 is provided before the amplification stage 20. In the analogue amplification stage 20, the AC voltage across the coil 14 is amplified and the amplified AC voltage signal is inputted into an analogue to digital converter 22 of a microcontroller 24.

The microcontroller 24 controls a gain control unit 26 which in turn controls the gain of the analogue amplification stage 20. When the microcontroller 24 detects that the amplitude of the converted AC voltage signal has reached a predetermined value, it generates a control signal to the gain control unit 26, in response to which the gain control unit 26 reduces the gain of the amplification stage 20. Thereby, saturation of the amplification stage 20 can be avoided and measurements can continue for higher AC voltage signals from the coil 14.

In the microcontroller 24, the converted AC voltage signal is correlated with the control signals sent to the gain control unit 26, and the control unit 24 generates an output signal 28 which is representative of waveform, which includes the amplitude, phase and harmonic content of the AC voltage signal in the coil 14, which is a measure for the alternating current signal in the power line 10.

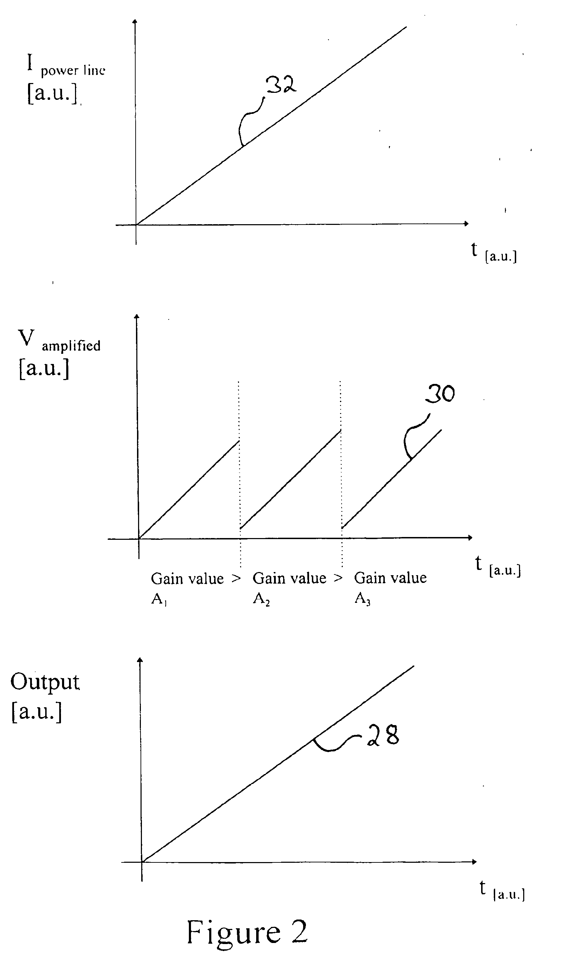

In Figures 2a to c, the output signal 28, the amplified voltage signal 30 and the amplitude of an AC signal 32 in the power line 10 are illustrated.

Referring again to Figure 1, the device 16 further comprises an offset compensation unit 34. The offset compensation unit 34 receives a digital signal from the micro controller 24 representative of a DC component in the amplified AC voltage signal. The offset compensation unit 34 outputs a DC trimming signal which is added through a resistor 36 to the integrated AC voltage signal across the coil 14 at the input of the amplification stage 20.

Within the offset compensation unit 34, the amplitude of the generated DC trimming signal is varied to maintain the digital DC component signal received from the microcontroller 24 at a minimum. This.corresponds to a fixed offset of the analogue signal entering the A/D converter 22. This can allow the amplification stage 20 to be operated at high gains without loss of performance caused by amplification of DC offset voltages.

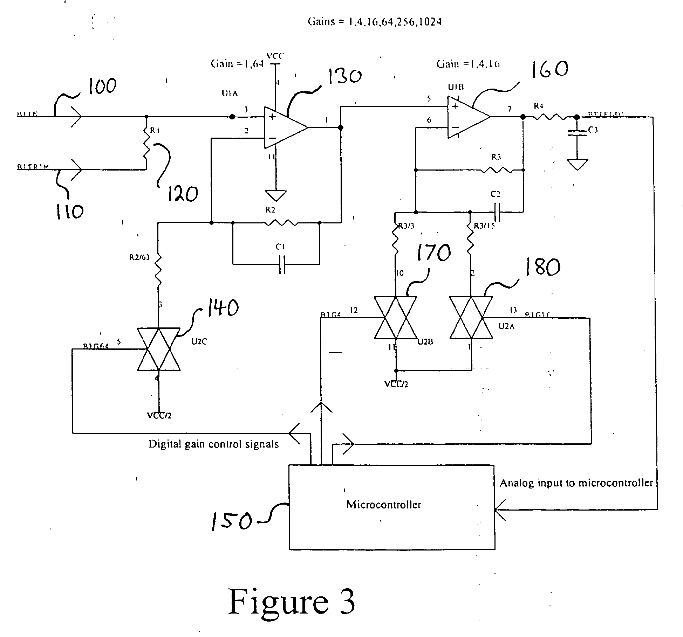

Turning now to Figure 3, the input signal 100 and an offset correction signal 110 are added through resistor 120. This signal is applied to the non-inverting input of operational amplifier 130. The DC gain of amplifier 130 is equal to $G = 1 + \dfrac{R2}{R_{in}}$, where $R_{in}$ is the input resistance between the inverting input of the amplifier and the reference voltage for the amplifier (VCC/2). Device 140 is a digitally controlled analog switch that is chosen to have an "off" resistance much higher than the resistor labelled R2/63. Similarly, the "on" resistance of the analog switch is chosen to be much less than the resistor labelled R2/63. Thus, when a control signal from the microcontroller 150 is activated, 140 is switched "ON", its resistance is low, so the DC gain of the amplifier 130 is given by $G \approx 1 + \dfrac{R2}{R2 / 63} = 1 + 63 = 64.$ When device 140 is switched "OFF", its resistance is high, so the DC gain of the amplifier is given by $G \approx 1 + \dfrac{R2}{\infty} = 1 + 0 = 1.$ Thus, the activation signal from the microcontroller 150 is used to set the DC gain of the amplifier 130 to either 64 or 1. Capacitor C1 is a small value device and is used to filter out ringing in the output signal following a gain change.

Amplifier 160 amplifies the signal from amplifier 130 and has gains set by R3, R3/3, R3/15, switch 170, and switch 180. The gains of this stage are shown below:

| Signal labelled B1G16 | Signal labelled B1G4 | Gain of Amplifier 160 |
|---|---|---|
| 0 | 0 | 1 |
| 0 | 1 | 4 |
| 1 | 0 | 16 |

By combining the gains of amplifiers 130 and 160, the following gain settings are possible:

| Signal labelled B1G64 | Signal labelled B1G16 | Signal labelled B1G4 | Gain (total) |
|---|---|---|---|
| 0 | 0 | 0 | 1 |
| 0 | 0 | 1 | 4 |
| 0 | 1 | 0 | 16 |
| 1 | 0 | 0 | 64 |
| 1 | 0 | 1 | 256 |
| 1 | 1 | 0 | 1024 |

The resistor R4 and capacitor C3 are used to lowpass filter the signal prior to the analog to digital converter in the microcontroller.

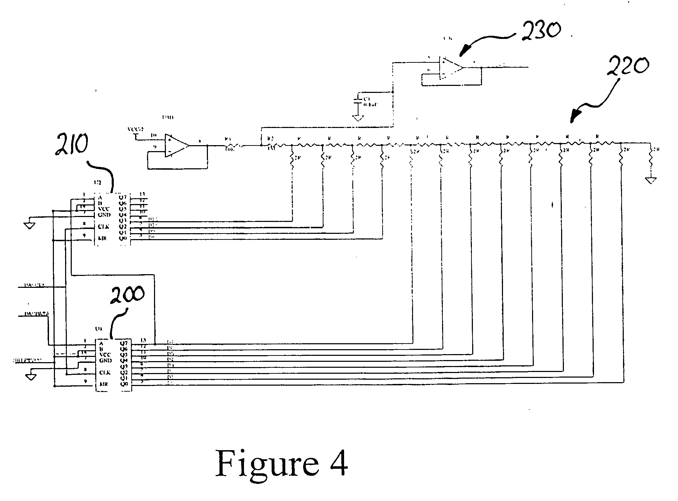

Turning now to Figure 4, the circuitry described below provides a technique to digitally correct for offset voltage in low cost, low power operational amplifiers. This allows the amplifiers to be operated at high gains without loss of performance caused by amplification of offset voltages.

Circuit Operation:

Devices 200 and 210 are serial to parallel shift registers. The most significant bit of shift register 200 is named D7 and is connected to the input of shift register 210. This gives a twelve digital output DO-D11. The inputs to the shift register (200 + 210) are generated by the microcontroller and are labelled DACDATA and DACCLK. These outputs are connected to the R-2R resistor network 230 to form a digital to analog converter. The output range of this analog to digital converter is from zero to (4095/4096)(SHIFTVCC), when SHIFTVCC is a predetermined DC signal. The output of the digital to analog converter is attenuated by resistor R1 and R2 and added to voltage VCC/2 to give a small voltage that varies around VCC/2. This voltage is filtered by C1 and buffered by buffer 230 to give signal B1TRIM.

The trimming software functions by setting the amplifier circuit shown in Figure 3 to maximum gain. In the presence of a low input signal, the value of B1TRIM that minimises the DC offset voltage seen by the microcontroller 150 is obtained using a binary search technique.

Returning now to Figure 1, the microcontroller 24 also performs an analysis of the frequency components of the amplified AC voltage signal, and thus of the frequency components of the magnetic field 12.

A lowpass filter is used to provide a signal proportional to the amplitude of the mains frequency component of the magnetic field ($M_1$). A bandpass filter is used to provide a signal proportional to the second harmonic component of the magnetic field ($M_2$). If the ratio of $M_2 / M_1$ exceeds a predetermined ratio, then the magnetic field signal is determined to be caused by magnetising inrush current.

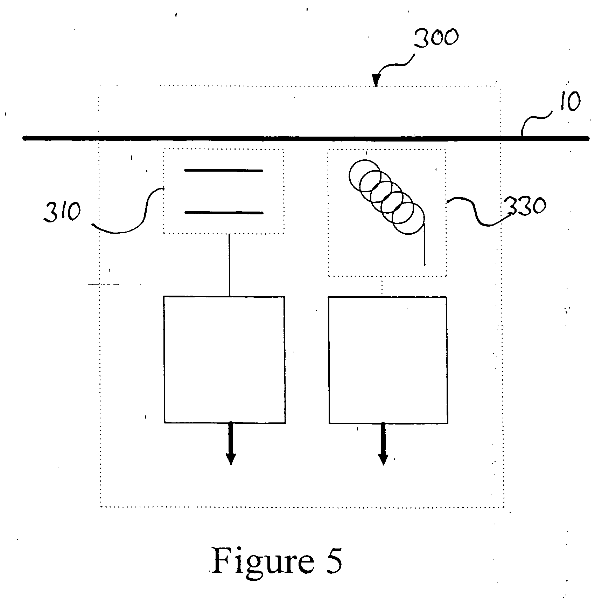

In Figure 5, in another embodiment a device 300 further comprises a capacitor arrangement 310 for measuring the electric field generated by the AC voltage signal on the power line 10. Both the signal from the capacitor arrangement 310 and the coil arrangement 330 are processed substantially as described before for the embodiment incorporating only a coil for the measurement of magnetic fields. Similarly as for the magnetic field measurements, this results in an electric field measurement in which a value representing a parameter of the electric field can be determined on a "continuous" scale.

The device 300 allows the detection of a common but elusive type of fault, commonly called self-clearing fault. These faults are characterised by high levels of current but do not cause a trip. By measuring an increase or decrease in the magnitude of the electric field, accompanied by changes in the current, self-clearing faults may be detected and stored.

The device 300 incorporating the capacitor arrangement 310 for measuring the electric field can also be used to perform what is commonly referred to as a "distance to fault calculation".

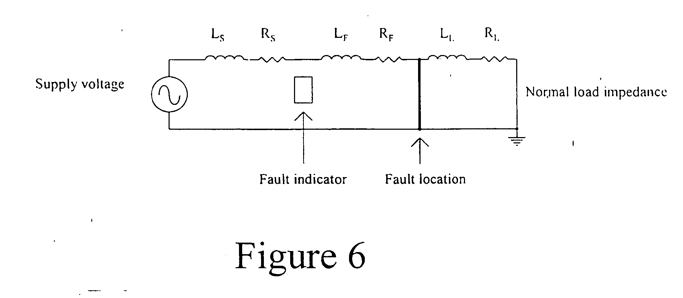

Referring now to Figure 6, the impedance of the line between the supply and the fault indicator is dominated by inductance $L_s$ and resistance $R_s$.

The impedance of the line between the fault indicator and the fault is dominated by inductance $L_F$ and resistance $R_F$.

The impedance of the line and load beyond the fault location is dominated by inductance $L_L$ and resistance $R_L$.

During the fault, it is assumed that the voltage at the fault is small compared to the supply voltage.

The voltage seen at the fault indicator is:

$$V_F = i_F R_F + L_F \frac{diF}{dt}, \qquad\qquad 1.1$$

where iF is the fault current and $\dfrac{diF}{dt}$ is the time derivative of the fault current.

If the voltage at the fault indicator is measured when iF is zero, then we have:

$$V_F = L_F \frac{di_F}{dt}\bigg|_{iF=0}$$

Rearrangement gives

$$L_F = V_F \frac{dt}{diF}\bigg|_{iF=0} \qquad\qquad 1.2$$

Thus, we may calculate the inductance of the line between the fault indicator and the fault.

Now, the per/metre inductance of the line is a constant that varies little with the configuration or voltage of the line. Thus it is considered to be approximately constant for all lines. We may write:

$$L_F = k \times d,$$

where k is the inductance per metre and d is the length of the line in metres.

Similarly, we have:

$$d = \frac{L_F}{k}. \qquad\qquad 1.3$$

Combining (1.2) and (1.3) gives

$$d = \frac{V_F \dfrac{dt}{di_F}\bigg|_{iF=0}}{k} \qquad\qquad 1.4$$

Equation (1.4) is the basis for the distance to fault measurement technique. Note that this technique is used in other products.

If several devices incorporating electrical field measurements components are used, the distance to fault reported by each indicator may be used to refine the search for the location of the fault.

It will therefore be apparent from the above description that the preferred embodiments of the present invention provide a method or means to obtain within the memory of a microprocessor, fully scaled current and voltage wave forms which have not been rectified. This may be achieved without saturation or phase shift over a much greater dynamic range than was previously available. Also, preferred embodiments of the invention allow a user to establish multiple parameters of these waveforms which can then be used to base decisions on the presence of fault current. Each additional waveform parameter aids in the process deciding what is a fault current.

Currently available devices on the band are not able to cover the same dynamic range, maintain scaling, maintain the same level of waveform information, or combine the same range of waveform parameters in decision making. This is in part due to the available devices requiring rectification of the measured waveform.

It will be appreciated by a person skilled in the art that numerous variations and/or modifications may be made to the present invention as shown in the specific embodiments without departing from the scope of the invention as defined by the claims. The present embodiments are, therefore, to be considered in all respects to be illustrative and not restrictive.

For example, it will be appreciated that the present invention is not limited to measurements performed on a single conductor, but rather the measurements could be conducted on a plurality of adjacent power lines. In such circumstances, one or more sensors (such as coil 14 of Figure 1) could be used.

For example, it will be appreciated that the measurement may also be performed utilising two or more coils with an angular offset between them to establish the characteristics of the magnetic field.

**Claims**

1. A method for measuring at least one characteristic parameter of an alternating current in a conductor, the method comprising the steps of:

   - measuring the magnetic field (12) around the conductor at a point along the conductor (10);
   - deriving an analogue voltage signal (14) representative of the measured magnetic field ;
   - adding a direct current (DC) (34, 36) offset signal to an alternating current (AC) component of the measured magnetic field;
   - amplifying (20) the analogue voltage signal;
   - converting (22) the amplified voltage signal into a digital voltage signal;
   - measuring the digital voltage signal and, when the amplitude of digital voltage signal reaches a predetermined value, adjusting a gain setting (26) of the amplification; and
   - generating an output signal (28) representative of the parameter of the alternating current based on the amplified voltage signal and the gain setting.

2. A method as claimed in claim 1, wherein the parameter of the alternating current comprises one of the group of waveform characteristics of the alternating current; phase of the alternating current; harmonic content of the alternating current; and a derivative of the alternating current.

3. A method as claimed in claims 1 or 2, further comprising the step of integrating the analogue voltage signal for obtaining the waveform of the alternating current in the conductor.

4. A method as claimed in any one of the preceding claims wherein the step of adding a DC offset signal comprises the step of varying the DC offset signal in response to a DC component in the digital voltage signal.

5. A method as claimed in any one of the preceding claims, further comprising the step of digitally filtering the digital voltage signal to determine the ratio of a mains voltage signal at a mains frequency of the conductor and a harmonic voltage signal at an harmonic of the mains frequency.

6. A method as claimed in claim 5, wherein a second harmonic of the mains frequency is measured for determining whether a magnetic field signal around the conductor is caused by magnetising inrush current.

7. A method as claimed in any one of the preceding claims further comprising the steps of:

   - measuring an electric field in the vicinity of the conductor; and
   - deriving a second analogue voltage signal representative of the measured electric field in the vicinity of the conductor.

8. A method as claimed in claim 7, wherein the step of measuring the electric field comprises the step of placing a capacitor arrangement in the vicinity of the conductor; and the method further comprises the steps of:

   - amplifying the second analog voltage signal;
   - converting the amplified second voltage signal into a second digital voltage signal;
   - measuring the second digital voltage signal and, when the amplitude of the second digital voltage signal reaches a second predetermined value, adjusting a second gain setting of the amplification;
   - and generating a second output signal representative of at least one parameter of a voltage signal in the conductor based on the amplified second voltage signal and the second gain setting.

9. An apparatus (16) for measuring at least one characteristic parameter of an alternating current in a conductor, the apparatus comprising:

- measuring means for measuring the magnetic (10) field (12) around the conductor at a point along the conductor;
- means for deriving (14) an analogue voltage signal representative of the measured magnetic field;
- trimming means for providing a DC offset (34, 36) signal to an AC component of the measured magnetic field;
- amplification means (20) for amplifying the analogue voltage signal;
- converting means (22) for converting the amplified voltage signal into a digital voltage signal;
- gain control means for adjusting a gain (26) setting of the amplification depending on the amplitude of the digital voltage signal; and
- means for generating an output signal (28) representative of the parameter of the alternating current based on the amplified voltage signal and the gain setting.

10. An apparatus as claimed in claim 9, wherein the parameter of the alternating current comprises one of the group of a waveform characteristic of the alternating current; phase of the alternating current; harmonic content of the alternating current; and a derivative of the alternating current.

11. An apparatus as claimed in claim 9 or 10, further comprising means for integrating the analogue voltage signal to obtain the waveform of the alternating current in the conductor.

12. An apparatus as claimed in any one of claims 9 to 11, the apparatus further comprising filtering means for filtering the digital signal and means for determining the ratio of a mains voltage signal at a mains frequency of the conductor and an harmonic voltage signal at an harmonic of the mains frequency.

13. An apparatus as claimed in any one of claims 9 to 12, the apparatus further comprising a second measuring means for measuring an electric field in the vicinity of the conductor; and a second means for deriving a second analogue voltage signal corresponding to the measured electric field in the vicinity of the conductor.

14. An apparatus as claimed in claim 13, the apparatus further comprising:

- second amplification means for amplifying the second analog voltage signal;
- second converting means for converting the second amplified voltage signal into a second digital voltage signal;
- second gain control means for adjusting a second gain setting of the second amplification depending on the second digital voltage signal;
- and a second means for generating an output signal representative of at least one parameter of a voltage signal in the conductor based on the second amplified voltage signal and the second gain setting.

15. An apparatus as claimed in claim 14, further comprising second trimming means for providing a second DC offset correction signal to correct a second DC offset of the second amplification means.

16. An apparatus as claimed in any one of claims 9 to 15, wherein the first and/or the or a second amplification means each comprises first and second operational amplifiers in series, wherein the analogue voltage signal is applied to the non-inverting input of the first operational amplifier, and the output of the first operational amplifier is connected to the non-inverting input of the second operational amplifier.

17. An apparatus as claimed in any one of claims 9 to 16, wherein the first and/or the or a second gain control means each comprises a digitally controlled analogue switch having a low "off" resistance and a high "on" resistance.

18. An apparatus as claimed in any one of claims 9 to 17, wherein-the first and/or the or a second trimming means each comprise a serial to parallel shift register, wherein the outputs of the shift register are connected to a resister network to form a digital to analogue converter.

**Patentansprüche**

1. Verfahren zum Messen mindestens eines Kennparameters eines Wechselstroms in einem Leiter, wobei das Verfahren die folgenden Schritte umfasst:

- Messen des Magnetfelds (12) um den Leiter an einem Punkt entlang des Leiters (10);
- Ableiten eines analogen Spannungssignals (14), das repräsentativ für das gemessene Magnetfeld ist;
- Hinzufügen eines Gleichstrom-Versatzsignals (DC-Versatzsignals) (34, 36) zu einer Komponente eines Wechselstroms (AC) des gemessenen Magnetfelds;
- Verstärken (20) des analogen Spannungssignals;
- Umwandeln (22) des verstärkten Spannungssignals in ein digitales Spannungssignal;
- Messen des digitalen Spannungssignals und, wenn die Amplitude des digitalen Spannungssignals einen vorbestimmten Wert erreicht, Einstellen einer Verstärkungseinstellung (26) für die Verstärkung; und
- Generieren eines für den Parameter des Wechselstroms repräsentativen Ausgangssignals (28) auf Grundlage des verstärkten Spannungssignals und der Verstärkungseinstellung.

2. Verfahren nach Anspruch 1, wobei der Parameter des Wechselstroms die Wellenformcharakteristik, die Phase des Wechselstroms, den Oberschwingungsgehalt des Wechselstroms oder eine Ableitung des Wechselstroms umfasst.

3. Verfahren nach Anspruch 1 oder 2, darüber hinaus den Schritt des Integrierens des analogen Spannungssignals umfassend, um die Wellenform des Wechselstroms im Leiter zu erhalten.

4. Verfahren nach einem der vorhergehenden Ansprüche, wobei der Schritt des Hinzufügens eines DC-Versatzsignals den Schritt des Abänderns des DC-Versatzsignals im Ansprechen auf eine DC-Komponente im digitalen Spannungssignal umfasst.

5. Verfahren nach einem der vorhergehenden Ansprüche, darüber hinaus den Schritt des digitalen Filterns des digitalen Spannungssignals umfassend, um das Verhältnis eines Netzspannungssignals bei einer Netzfrequenz des Leiters und eines Oberschwingungsspannungssignals bei einer Oberschwingung der Netzfrequenz zu bestimmen.

6. Verfahren nach Anspruch 5, wobei eine zweite Oberschwingung der Netzfrequenz gemessen wird, um zu bestimmen, ob durch einen magnetisierenden Einschaltstrom ein Magnetfeldsignal um den Leiter bewirkt wird.

7. Verfahren nach einem der vorhergehenden Ansprüche, darüber hinaus die folgenden Schritte umfassend:

- Messen eines elektrischen Felds in der unmittelbaren Umgebung des Leiters; und
- Ableiten eines zweiten analogen Spannungssignals, das für das in der unmittelbaren Umgebung des Leiters gemessene elektrische Feld repräsentativ ist.

8. Verfahren nach Anspruch 7, wobei der Schritt des Messens des elektrischen Felds den Schritt umfasst, eine Kondensatoranordnung in der unmittelbaren Umgebung des Leiters anzuordnen; und das Verfahren darüber hinaus die folgenden Schritte umfasst:

- Verstärken des zweiten analogen Spannungssignals;
- Umwandeln des verstärkten zweiten Spannungssignals in ein zweites digitales Spannungssignal;
- Messen des zweiten digitalen Spannungssignals und, wenn die Amplitude des zweiten digitalen Spannungssignals einen zweiten vorbestimmten Wert erreicht, Einstellen einer zweiten Verstärkungseinstellung für die Verstärkung;
- und Generieren eines für mindestens einen Parameter eines Spannungssignals im Leiter repräsentativen zweiten Ausgangssignals auf Grundlage des verstärkten zweiten Spannungssignals und der zweiten Verstärkungseinstellung.

9. Vorrichtung (16) zum Messen mindestens eines Kennparameters eines Wechselstroms in einem Leiter, wobei die Vorrichtung umfasst:

- eine Messeinrichtung zum Messen des Magnetfelds (12) um den Leiter an einem Punkt entlang des Leiters (10);
- eine Einrichtung zum Ableiten (14) eines analogen Spannungssignals, das repräsentativ für das gemessene Magnetfeld ist;
- eine Trimmeinrichtung, um einer AC-Komponente des gemessenen Magnetfelds ein DC-Versatzsignal (34, 36) bereitzustellen;
- eine Verstärkungseinrichtung (20) zum Verstärken des analogen Spannungssignals;

- eine Wandlereinrichtung (22) zum Umwandeln des verstärkten Spannungssignals in ein digitales Spannungssignal;
- eine Verstärkungsreglereinrichtung zum Einstellen einer Verstärkungseinstellung (26) für die Verstärkung in Abhängigkeit von der Amplitude des digitalen Spannungssignals; und
- eine Einrichtung zum Generieren eines für den Parameter des Wechselstroms repräsentativen Ausgangssignals (28) auf Grundlage des verstärkten Spannungssignals und der Verstärkungseinstellung.

**10.** Vorrichtung nach Anspruch 9, wobei der Parameter des Wechselstroms die Wellenformcharakteristik, die Phase des Wechselstroms, den Oberschwingungsgehalt des Wechselstroms oder eine Ableitung des Wechselstroms umfasst.

**11.** Vorrichtung nach Anspruch 9 oder 10, darüber hinaus eine Einrichtung zum Integrieren des analogen Spannungssignals umfassend, um die Wellenform des Wechselstroms im Leiter zu erhalten.

**12.** Vorrichtung nach einem der Ansprüche 9 bis 11, wobei die Vorrichtung darüber hinaus eine Filtereinrichtung, um das digitale Spannungssignal zu filtern, und eine Einrichtung zum Bestimmen des Verhältnisses eines Netzspannungssignals bei einer Netzfrequenz des Leiters und eines Oberschwingungsspannungssignals bei einer Oberschwingung der Netzfrequenz umfasst.

**13.** Vorrichtung nach einem der Ansprüche 9 bis 12, wobei die Vorrichtung darüber hinaus eine zweite Messeinrichtung umfasst, um ein elektrisches Feld in der Umgebung des Leiters zu messen, und eine zweite Einrichtung zum Ableiten eines zweiten analogen Spannungssignals, das dem in der Umgebung des Leiters gemessenen elektrischen Feld entspricht.

**14.** Vorrichtung nach Anspruch 13, wobei die Vorrichtung darüber hinaus umfasst:

- eine zweite Verstärkungseinrichtung, um das zweite analoge Spannungssignal zu verstärken;
- eine zweite Wandlereinrichtung, um das zweite verstärkte Spannungssignal in ein zweites digitales Spannungssignal umzuwandeln;
- eine zweite Verstärkungsreglereinrichtung, um eine zweite Verstärkungseinstellung für die zweite Verstärkung in Abhängigkeit vom zweiten digitalen Spannungssignal einzustellen;
- und eine zweite Einrichtung, um ein für mindestens einen Parameter eines Spannungssignals im Leiter repräsentatives Ausgangssignal auf Grundlage des zweiten verstärkten Spannungssignals und der zweiten Verstärkungseinstellung zu generieren.

**15.** Vorrichtung nach Anspruch 14, darüber hinaus eine zweite Trimmeinrichtung umfassend, um ein zweites DC-Versatz-Korrektursignal bereitzustellen, um einen zweiten DC-Versatz der zweiten Verstärkungseinrichtung zu korrigieren.

**16.** Vorrichtung nach einem der Ansprüche 9 bis 15, wobei die erste und/oder die oder eine zweite Verstärkungseinrichtung jeweils einen in Reihe geschalteten ersten und zweiten Operationsverstärker umfasst/umfassen, wobei das analoge Spannungssignal an den nicht invertierenden Eingang des ersten Operationsverstärkers angeschlossen ist, und der Ausgang des ersten Operationsverstärkers an den nicht invertierenden Eingang des zweiten Operationsverstärkers angeschlossen ist.

**17.** Vorrichtung nach einem der Ansprüche 9 bis 16, wobei die erste und/oder die oder eine zweite Verstärkungsreglereinrichtung jeweils einen digital gesteuerten analogen Schalter mit einem niedrigen Ausschaltwiderstand und einem hohen Einschaltwiderstand umfasst/umfassen.

**18.** Vorrichtung nach einem der Ansprüche 9 bis 17, wobei die erste und/oder die oder eine zweite Trimmeinrichtung jeweils ein Seriell-Parallel-Schieberegister umfasst/umfassen, wobei die Ausgänge des Schieberegisters an ein Widerstandsnetz angeschlossen sind, um einen D/A-Wandler zu bilden.

**Revendications**

**1.** Procédé pour mesurer au moins un paramètre caractéristique d'un courant alternatif dans un conducteur, le procédé comprenant les étapes consistant à :

- mesurer le champ magnétique (12) autour du conducteur à un point le long du conducteur (10) ;
- dériver un signal de voltage analogique (14) représentatif du champ magnétique mesuré ;
- ajouter un signal de décalage (34, 36) à courant continu (DC) à une composante de courant alternatif (AC) du champ magnétique mesuré ;
- amplifier (20) le signal de voltage analogique ;
- convertir (22) le signal de voltage amplifié en un signal de voltage numérique ;
- mesurer le signal de voltage numérique et, quand l'amplitude du signal de voltage numérique atteint une valeur prédéterminée, ajuster un réglage de gain (26) de l'amplification ; et
- générer un signal de sortie (28) représentatif du paramètre de courant alternatif en se basant sur le signal de voltage amplifié et sur le réglage de gain.

2. Procédé selon la revendication 1, dans lequel le paramètre du courant alternatif comprend l'un des paramètres du groupe comprenant les caractéristiques de la forme d'onde du courant alternatif ; la phase du courant alternatif ; le contenu harmonique du courant alternatif ; et une dérivée du courant alternatif.

3. Procédé selon l'une des revendications 1 ou 2, comprenant en outre l'étape consistant à intégrer le signal de voltage analogique pour obtenir la forme d'onde du courant alternatif dans le conducteur.

4. Procédé selon l'une quelconque des revendications précédentes, dans lequel l'étape consistant à ajouter un signal de décalage en courant continu comprend l'étape consistant à faire varier le signal de décalage en réponse à une composante de courant continu dans le signal de voltage numérique.

5. Procédé selon l'une quelconque des revendications précédentes, comprenant en outre l'étape consistant à filtrer numériquement le signal de voltage numérique pour déterminer le rapport d'un signal de voltage principal à une fréquence principale du conducteur sur un signal de voltage harmonique à une harmonique de la fréquence principale.

6. Procédé selon la revendication 5, dans lequel une seconde harmonique de la fréquence principale est mesurée pour déterminer si un signal de champ magnétique autour du conducteur est provoqué par un courant entrant à effet magnétique.

7. Procédé selon l'une quelconque des revendications précédentes, comprenant en outre les étapes consistant à :

   - mesurer un champ électrique au voisinage du conducteur ; et
   - dériver un second signal de voltage analogique représentatif du champ électrique mesuré au voisinage du conducteur.

8. Procédé selon la revendication 7, dans lequel l'étape consistant à mesurer le champ électrique comprend l'étape consistant à placer un agencement à capacité au voisinage du conducteur ; et le procédé comprend en outre les étapes consistant à :

   - amplifier le second signal de voltage analogique ;
   - convertir le second signal de voltage amplifié en un second signal de voltage numérique ;
   - mesurer le second signal de voltage numérique et, quand l'amplitude du second signal de voltage numérique atteint une seconde valeur prédéterminée, ajuster un second réglage de gain de l'amplification ;
   - et générer un second signal de sortie représentatif d'au moins un paramètre d'un signal de voltage dans le conducteur en se basant sur le second signal de voltage amplifié et sur le second réglage de gain.

9. Appareil (16) pour mesurer au moins un paramètre caractéristique d'un courant alternatif dans un conducteur, l'appareil comprenant :

   - des moyens de mesure pour mesurer le champ magnétique (12) autour du conducteur (10) en un point le long du conducteur ;
   - des moyens (14) pour dériver un signal de voltage analogique représentatif du champ magnétique mesuré ;
   - des moyens de réglage pour ajouter un signal de décalage en courant continu (34, 36) à une composante en courant alternatif du champ magnétique mesuré ;
   - des moyens d'amplification (20) pour amplifier le signal de voltage analogique ;
   - des moyens de conversion (22) pour convertir le signal de voltage amplifié en un signal de voltage numérique ;
   - des moyens de commande de gain pour ajuster un réglage de gain (26) de l'amplification en dépendance de l'amplitude du signal de voltage numérique ; et

- des moyens pour générer un signal de sortie (28) représentatif du paramètre du courant alternatif en se basant sur le signal de voltage amplifié et sur le réglage de gain.

**10.** Appareil selon la revendication 9, dans lequel le paramètre du courant alternatif comprend l'un des paramètres du groupe comprenant une caractéristique de forme d'onde du courant alternatif ; la phase du courant alternatif ; le contenu harmonique du courant alternatif ; et une dérivée du courant alternatif.

**11.** Appareil selon la revendication 9 ou 10, comprenant en outre des moyens pour intégrer le signal de voltage analogique pour obtenir la forme d'onde du courant alternatif dans le conducteur.

**12.** Appareil selon l'une quelconque des revendications 9 à 11, l'appareil comprenant en outre des moyens de filtrage pour filtrer le signal numérique et des moyens pour déterminer le rapport d'un signal de voltage principal à une fréquence principale du conducteur sur un signal de voltage harmonique à une harmonique de la fréquence principale.

**13.** Appareil selon l'une quelconque des revendications 9 à 12, l'appareil comprenant en outre des seconds moyens de mesure pour mesurer un champ électrique au voisinage du conducteur ; et des seconds moyens pour dériver un second signal de voltage analogique correspondant au champ électrique mesuré au voisinage du conducteur.

**14.** Appareil selon la revendication 13, ledit appareil comprenant en outre :

- des seconds moyens d'amplification pour amplifier le second signal de voltage analogique ;
- des seconds moyens de conversion pour convertir le second signal de voltage amplifié en un second signal de voltage numérique ;
- des seconds moyens de commande de gain pour ajuster un second réglage de gain de la seconde amplification en dépendance du second signal de voltage numérique ;
- et des seconds moyens pour générer un signal de sortie représentatif d'au moins un paramètre d'un signal de voltage dans le conducteur en se basant sur le second signal de voltage amplifié et sur le second réglage de gain.

**15.** Appareil selon la revendication 14, comprenant en outre des seconds moyens de réglage pour ajouter un second signal de correction de décalage à courant continu pour corriger un second décalage à courant continu des seconds moyens d'amplification.

**16.** Appareil selon l'une quelconque des revendications 9 à 15, dans lequel les premiers et/ou les seconds moyens d'amplification comprennent chacun un premier et un second amplificateur opérationnel en série, le signal de voltage analogique étant appliqué à l'entrée non-inverseuse du premier amplificateur opérationnel, et la sortie du premier amplificateur opérationnel est connectée à l'entrée non-inverseuse du second amplificateur opérationnel.

**17.** Appareil selon l'une quelconque des revendications 9 à 16, dans lequel les premiers et/ou les seconds moyens de commande de gain comprennent chacun un commutateur analogique commandé numériquement, présentant une faible résistance "off" (de coupure) et une forte résistance "on" (de fermeture).

**18.** Appareil selon l'une quelconque des revendications 9 à 17, dans lequel les premiers et/ou les seconds moyens de réglage comprennent chacun un registre à décalage série/parallèle, dans lequel les sorties du registre à décalage sont connectées à un réseau de résistances pour former un convertisseur numérique/analogique.

Figure 1

I power line
[a.u.]

32

t [a.u.]

V amplified
[a.u.]

30

t [a.u.]

Gain value >   Gain value >   Gain value
A₁             A₂             A₃

Output
[a.u.]

28

t [a.u.]

Figure 2

Figure 3

Figure 4

Figure 5

$L_S$      $R_S$      $L_F$      $R_F$      $L_l$      $R_l$

Supply voltage

Normal load impedance

Fault indicator      Fault location

# Figure 6

Figure 7

Conductor

$\int dt$

1.0

0.001

Relative coil output
vs position of conductor

# Figure 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4947126 A
- US 5270898 A
- US 5473244 A